# EUROPEAN PATENT SPECIFICATION

(11) **EP 3 846 605 B1**
(45) Date of publication and mention of the grant of the patent: **02.08.2023**
(21) Application number: 20217992.5
(22) Date of filing: 31.12.2020
(51) Int. Cl.: H05K 13/04, H05K 13/08, B23K 1/018, B23K 3/08

(54) **APPARATUS FOR REMOVING COMPONENTS FROM PRINTED CIRCUIT BOARDS AND A METHOD FOR REMOVING COMPONENTS IN THIS APPARATUS**
VORRICHTUNG ZUM ENTFERNEN VON KOMPONENTEN AUS LEITERPLATTEN UND VERFAHREN ZUM ENTFERNEN VON KOMPONENTEN IN DIESER VORRICHTUNG
APPAREIL DE RETRAIT DE COMPOSANTS À PARTIR DE CARTES DE CIRCUIT IMPRIMÉ ET PROCÉDÉ DE RETRAIT DE COMPOSANTS DANS LEDIT APPAREIL

(30) Priority: 31.12.2019 CZ 20190813
(43) Date of publication of application: 07.07.2021
(73) Proprietor: Ceske vysoke uceni technicke v Praze, 160 00 Praha 6 - Dejvice (CZ)
(72) Inventor: KLOF, Radek, 41301 Vrazkov (CZ); TICHÝ, Pavel, 13000 Praha 3, Vinohrady (CZ); HÁJEK, Jirí, 19900 Praha 9, Letnany (CZ); DUSEK, Karel, 29001 Podebrady III (CZ)
(74) Representative: Kratochvil, Vaclav

(56) References cited:
- US-A- 5 423 931

## Description

### Technical Field

The present invention relates to the field of removing bonded and soldered components from the surface of printed circuit boards, in particular those of mobile electronic devices such as mobile phones, tablets, laptops, personal portable computing units, so-called handhelds, and others.

### Background Art

Failures of portable electronic devices are a common type of defect having their respective levels of repair: (a) replacement, (b) software reinstallation, (c) intervention on a printed circuit board with a replacement of a defective com ponent.

Portable electronic devices are designed to have maximum mechanical resistance without compromising the functionality of the device. E.g., Motorola guarantees for its portable computer units thousand falls from one meter (from human hand) onto a concrete surface without disrupting the functionality of the device. To achieve such a quality guarantee of the Service Level Agreement (SLA), high-quality mechanical design is required. The individual components in the device are therefore not only soldered but also bonded to withstand this mechanical stress.

However, a failure of the device (i.e., its whole or partial malfunction) is not caused by the malfunction of all components of this device, but usually only one of them. At present, there is no quality method of removal of such a soldered and bonded component without mechanical or thermal damage to other system components and the surroundings of this component. These are mainly the other chips, GPS modules, GSM modules, cameras, etc., which are expensive components. An example is a mobile phone that everyone knows. It is standard in the field of soldering that particularly sensitive components can be replaced only once because their repeated heating during soldering causes the internal structure to collapse or malfunction. At the same time, repeated heating will damage the printed circuit board and may not provide the required functionality.

Methods known from the state of the art attempt to remove the defective component either by:
- Tearing - here, however, the technological surroundings of the defective component are disturbed and thus the printed circuit board (always multilayer) is degraded.
- Gradual heating of the defective component (by various heat and light fluxes) and subsequent use of chemical agents to soften the adhesive, which holds the component to provide the mechanical strength. The problem with this method is that the chemical plasticizer never gets under the defective component evenly and this method is not effective enough. Examples of these methods can be found, for example, in the following patents: CN10448579, KR20150020229, CN10778274.

An example of combination of heating and tearing for component removal is disclosed in US5423931A. The mechanical tearing is preceded by heating up to 350 °C, which is necessary to soften the resin and the soldered connections between the component and the board. Then, the residual resin is removed by electromagnetic radiation.

With the methods including heating and/or tearing, the printed circuit board or the surroundings of the defective component are always damaged, so that the device cannot be put back into operation. The Service Level Agreement (SLA) guarantee prescribes that the device, after the repair, is of the same strength and quality parameters as the new equipment, but this cannot be achieved by the thermal or mechanical tearing method.

As another possible method using available art, there is the possibility of removing the component using a milling machine only, i.e., with the available mechanical engineering equipment that would be used for this operation.

Although this method is obvious, the required result is not guaranteed because the accuracy of the removal is not guaranteed, the printed circuit board may be damaged, the cleanliness of the printed circuit board is not guaranteed after the removal of the defective component. The existence of any residue on the printed circuit board in such method of removal is a source of consecutive failures and dysfunctions of the device - we are dealing with dimensions of tenths of a millimetre among the individual components on the printed circuit board.

The main disadvantages of the hitherto known simple milling methods consist in that these methods do not use point measuring on the component and on the printed circuit board and do not link the results of this measurement with work procedures of the machining tool, do not use machining tools with a different working area for different material layers of the removed components, and do not allow partial or complete automation of the process. Thus, the big disadvantage is that the specific defect is solved only individually in each case when the milling procedure is set up individually for the given component. Problems related to different mutual inclination of the component surface and the printed circuit board are not solved. The existing methods apply "contour" milling, i.e., in individual parallel layers, with each of the layers usually being removed by moving the machining tool relative to the component in rows and columns. Thus, they do not make possible the removal of the component with regard to its relief and possible other irregularities, i.e., according to instructions, when the machining tool would perform a compound movement in space with respect to the component, along in least two non-parallel axes simultaneously. The accuracy of the component removal by the simple milling method is therefore poor, component removal is imperfect and there is a risk of damage to the printed circuit board. In addition, the method does not allow any increase in accuracy or degree of automation for other components of the same type.

The objective of removing a defective component is not to remove the component by itself, but above all ensuring and guaranteeing the integrity of the motherboard for soldering an additional component, as well as the capability to remove similar components repeatedly in the same quality.

### Summary of Invention

The above-mentioned drawbacks of prior art are eliminated by an apparatus for removing components from printed circuit boards and the method of removing components by this apparatus according to claim 1.

A measuring method is defined in claim 7. The component typically consists of two materials, so it is proposed to remove it, with an advantage, using two different machining tools. The apparatus is designed in such a way that it allows for at least one machining tool a compound mutual movement of this machining tool and the fastening device along at least two non-parallel axes of movement simultaneously, i.e., the removal of the component can also proceed along a curve in a plane or an uneven surface in space, thus not being limited only to the removal of parallel layers of material and to regularly arranged components, as is known from prior art. The solution according to the present invention comprises an algorithm for calculating the mutual inclination of the surfaces of the component being removed and the printed circuit board, which allows to control the depth of the tool engagement, ensuring the integrity of the base layer of the printed circuit board.

The object of the present invention is fulfilled by an apparatus and by a method as defined in independent claims 1 and 7. Preferred embodiments are defined in the dependent claims.

Thus, a non-invasive solution is proposed for removing components from printed circuit boards, the use of which does not damage the repaired device. Only the component of interest is removed without damaging the other elements of the device. At the same time, it is a "cold" method - when removing the component of interest, there is no heating of its surroundings or the printed circuit board and thus there is no mechanical or thermal damage to the board and other components. The method can be applied repeatedly without limiting the number of these repetitions and with improving accuracy.

### Brief Description of Drawings

Some exemplary embodiments of the invention are shown in the attached figures.
Figure 1 shows the basic layout of the components of the apparatus for removing components 6 from the printed circuit boards 3, including an illustration of the possible directions of mutual movements and the axes of these mutual movements.
Figure 2 shows on a photograph an example of a printed circuit board with the component being removed 6 and other objects, wherein to the photograph a detail drawing of the component 6 being removed from the printed circuit board 3 is attached, including the designation of coordinate indicators 6.1, 6.2, 6.3.

### Preferred Embodiments of Invention

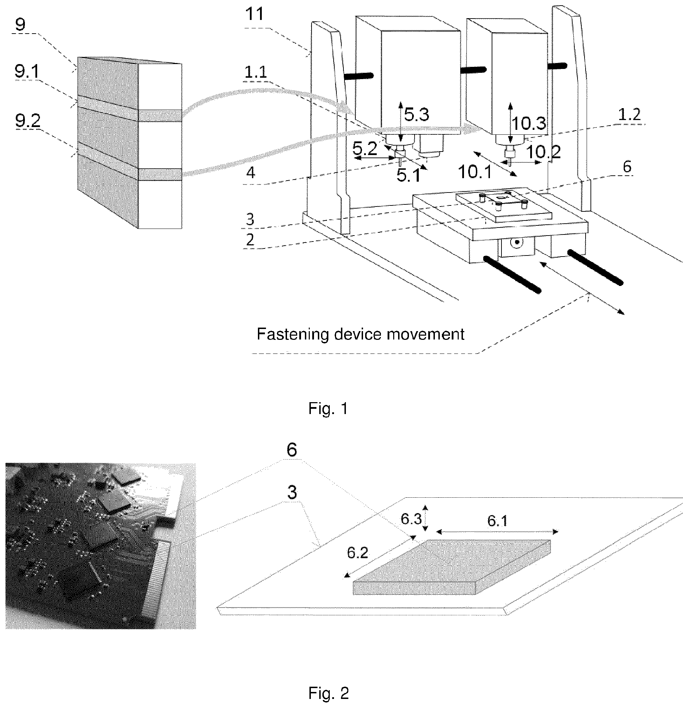

The apparatus for removing components 6 from printed circuit boards 3 in one possible embodiment is shown in Figure 1. The apparatus is generally equipped with at least one machining tool, in Figure 1 two machining tools are shown, namely the first machining tool 1.1 and the second machining tool 1.2. The apparatus is also equipped with a fastening device 2 for clamping the printed circuit board 3 and also by movable mechanisms for the mutual movement of at least one of the machining tools and the fastening device 2 along at least three different axes. This mutual movement can be realized in various manners: by moving the machining tool relative to the fastening device, by moving the fastening device 2 relative to the machining tool, or by moving the fastening device 2 and the machining tool simultaneously. In the exemplary embodiment in Figure 1 are displayed the first axes 5.1, 5.2, 5.3 of the mutual movement of the first machining tool 1.1 and the fastening device 2, and the second axes 10.1, 10.2, 10.3 of the mutual movement of the second machining tool 1.2 and the fastening device 2. In the selected case, the first machining tool 1.1 is movable along the first vertical axis 5.3 and along the first horizontal axis 5.2, the second machining tool is movable along the second vertical axis 10.3 and along the second horizontal axis 10.2 and the fastening device 2 is movable along the horizontal axis 5.1, which is also equivalent to movement along the horizontal axis 10.1. The mutual movement of the first machining tool 1.1 and the fastening device 2 thus takes place along three first axes 5.1, 5.2, 5.3, which are generally non-parallel to each other, and similarly the mutual movement of the second machining tool 1.2 and the fastening device 2 takes place along the three second axes 10.1, 10.2, 10.3 which are generally non-parallel to each other. In the example given, all the first axes 5.1, 5.2, 5.3 are perpendicular to each other and each of them is parallel to one of the second axes 10.1, 10.2, 10.3. The movement of the first machining tool 1.1 along the first vertical axis 5.3 and the movement of the second machining tool 1.2 along the second vertical axis 10.3 determine the depth of tool engagement, i.e., the amount of material abraded from the component being removed. However, the mutual movement of the fastening device 2 and the machining tool can, of course, be also realized in other ways and by different breakdowns of the individual device component movements along different axes than shown in Figure 1. It is clear, for example, that the possible movement of e.g., the first machining tool 1.1 rearwards relative to the coordinate system related to the ground would be in terms of the mutual movement of the first machining tool and fastening device 2 equivalent to the movement of the fastening device 2 forward in the coordinate system related to the ground.

The movable mechanisms can be implemented, for example, by means of a ball screw driven, for example, by stepper motors. In Figure 1, for example, the first machining tool 1.1 is driven by the first ball screw in the right-left horizontal direction, by the second ball screw in the vertical direction and the fastening device 2 is driven by the third ball screw in the anteroposterior horizontal direction. This arrangement works analogously for the second machining tool 1.2. In the exemplary embodiment according to Figure 1, both the first machining tool 1.1 and the second machining tool 1.2 are attached to a common frame 11.

In general, at least one of the machining tools and/or the fastening device 2 are connected to the movable mechanisms, thus ensuring the mutual movement of this machining tool and the fastening device.

The apparatus is also equipped with at least one measuring device 4 for measuring distances. The movable mechanisms and at least one measuring device are connected to the control unit 9.

It is important that the movable mechanisms are also adapted for compound mutual movement of at least one machining tool and fastening device 2 along at least two axes simultaneously, thus enabling continuous machining of e.g., curved surfaces, with the machining tool being able to follow a spatial curve or a surface in the component being removed, so that it is not limited to removing plane-parallel layers. Owing to this, the device can also accurately remove components 6 irregularly shaped, components 6 with an inclination relative to the printed circuit board 3, and similar.

It is advantageous if the moving mechanisms for the mutual movement of at least one of the machining tools and the fastening device 2 in terms of range, speed and direction of movement for each of the axes of this mutual movement are adjustable independently of the other axes of this mutual movement, as is in the embodiment according to Figure 1.

Since the material of the component being removed 6 is usually two-component, the machining tools are with an advantage selected from the group comprising the first machining tool 1.1 and the second machining tool 1.2, wherein the first machining tool 1.1 has a first working surface and the second machining tool 1.2 has a second working surface, the second working surface being different from the first working surface in at least one parameter selected from the group of shape, material, surface roughness. The machining tool is a milling machine or a grinder, the working surface is understood to mean, for example, the tip of this milling machine or grinder.

The usual arrangement is such that the first machining tool 1.1 has a working surface rougher than the second machining tool 1.2. The first machining tool is then used to remove the top layers of the component being removed, typically a plastic housing, and a lower rotational speed is also suitable so that the plastic does not overheat and char too much. The second machining tool 1.2 with a finer working surface is then used to remove the lower silicon layer, usually at higher rotational speeds. The machining tools are changeable, they can be interchanged, interchangeable tips can be inserted into the spindles of the machining tools 1.1, 1.2 attached to frame 11.

The control unit 9 therefore comprises a first block 9.1 of the work procedure for the first machining tool 1.1 and the fastening device 2, comprising instructions for the mutual movement of the first machining tool 1.1 and the fastening device 2 as well as for the rotational speed of the working surface of the first machining tool 1.1. Similarly, the control unit also comprises a second block 9.2 of the work procedure for the second machining tool 1.2 and the fastening device 2 comprising instructions for the mutual movement of the second machining tool 1.2 and the fastening device 2, e.g., for the rotational speed of the working surface of the second machining tool 1.2.

With an advantage, the measuring devices 1 comprise a camera and/or a laser and/or a mechanical probe.

Concurrently it is advantageous, if the at least one measuring device 1 is movable and is adapted for synchronous movement with at least one of the machining tools in the direction of at least two axes selected from the group of axes of mutual movement of this machining tool and the fastening device 2. These two movement axes of the mutual movement are optimally chosen so as to allow the movement of the measuring device 1 in a plane which forms as small an angle as possible with the plane of the component being removed 6.

Figure 1 shows an exemplary embodiment in which the measuring device 1 is fixedly connected to the first machining tool 1.1, with which it can also move synchronously with respect to the fastening device 2.

In the most advantageous embodiment, the apparatus is also equipped with an efficient and powerful extraction of machining residues, so that after the removal of the component of interest 6, the printed circuit board 3 is clean and ready for further use.

The method of removing components 6 from the printed circuit boards in the described apparatus is as follows: The printed circuit board 3 with the component 6 to be removed is clamped in the fastening device 2. Usually, but not necessarily, the planar dimensions of the component 6 are determined after clamping. The control unit 9 is usually connected to a computer and the planar dimensions of the component 6 can be determined, for example, in the case of a typical rectangular component 6, for example when the operator displays the camera image of the component 6 on a computer monitor, pointing the cursor at the three corners of the component, the position of the fourth corner of the component being calculated. However, it is also possible to use, for example, automatic image recognition and other methods.

The method according to the present invention further comprises the following steps:
a) a coordinate system for three-dimensional measurement is introduced with coordinate indicators 6.1, 6.2, 6.3, two of which are planar coordinate indicators 6.1, 6.2 and the third one is a height coordinate indicator 6.3, as shown in Figure 2. In this coordinate system, for at least three points on the surface of the component being removed 6, all three coordinates are measured for each of these points on the surface of the component being removed according to the three coordinate indicators 6.1, 6.2, 6.3. The measurement is also performed for at least three points positioned on the surface of the printed circuit board 3 and concurrently outside the component being removed 6. All three coordinates are measured according to the three coordinate indicators 6.1, 6.2, 6.3 for each of these points,
b) the mutual incline of the board 3 surface and the surface of the component being removed 6 is calculated, based on the measurement results,
c) the results of measurement and determination of the planar dimensions of the component are converted into the setting of the ranges of mutual movement of one of the machining tools and the fastening device 2,
d) the operator or control unit set the instructions for the directions and speeds of mutual movement of the given tool and the fastening device 2 and also the instructions for the rotational speed of the working surface of the given machining tool,
e) the settings made in steps c), d) are converted into a set of instructions for the mutual movement of the given machining tool and fastening device 2, this mutual movement comprising movement along three mutually non-parallel axes of mutual movement of this machining tool and the fastening device 2. In the case of removing components 6 the surface of which is not positioned in any of the planes determined by the pairs of axes selected from the group of axes of mutual movement of the given tool and the fastening device 2, this set of instructions also includes compound mutual movement performed simultaneously along at least two axes selected from the group of axes of mutual movement of the given machining tool and the fastening device 2,
f) the removal of the component 6 is executed by the machining tool according to the instruction set created in step e) and/or finishing of component 6 removal by the instruction set created in step e) or on the direct instructions of the operator, while if the removal of the component (6) by the machining tool has not been finished, the method continues by the following step g)
g) if in step f) the removal of the component 6 by the machining tool is not finished, the removal is interrupted and then steps a) to f) are repeated.

The ranges of mutual movement in step c) can be set, for example, for the first machining tool 1.1 according to the embodiment in Figure 1, for example as ranges of movement of the ball screws in the directions of each of the first axes 5.1, 5.2, 5.3. The directions in step d) can generally change over time, the speed of mutual movement of the given machining tool and the fastening device 2 as well as the speed of rotation of the working surface can also change over time, although constant rotational speeds can be used in both cases. All that has been stated in the previous sentence can be included in the instructions according to step d).

The compound movement in step e) can advantageously be used for components 6 with an inclined surface or for components of irregular shape. It is possible to remove the component along different curves or undulated surfaces, it is possible, for example, to start machining inside the surface of the component being removed 6 and move to its edges, simultaneously with the movement along the printed circuit board 3 change the depth of tool engagement, it is also possible to change the rotational speed of the working surface during machining, etc.

The mutual movement parameters of at least one of the machining tools and the fastening device 2, which include the direction, speed and range of this mutual movement, can be advantageously set in steps c), d) for each of the mutual movement axes of the given machining tool and the fastening device 2 independently of the mutual movement parameters for the other axes of mutual movement of this machining tool and the fastening device 2.

The measurement in step a) can be performed by the operator and/or using a camera and/or a laser and/or a mechanical probe.

If a camera is used, it is advantageous to have the aberrations corrected by software.

An advantageous embodiment is such where the camera participates in the measurement of planar coordinates according to the planar coordinate indicators 6.1, 6.2, where the points at which the planar coordinates are being determined are either selected by the operator based on the camera-mediated image or performed by automatic camera image processing and the points are selected accordingly, after which the positions of the above-mentioned selected points are measured in the image from the camera and subsequently converted to real values of the planar coordinates of these points in the direction of the area coordinate indicators 6.1, 6.2.

These can also be the same points that are used to determine the planar dimensions of the component 6.

The camera can therefore be used in several ways: for measuring points on the surface of the component 6 and on the surface of the printed circuit board 3, for in-process and final inspection of the component and its individual layers, for initial measurement of the component outline.

The measurement of the height coordinates according to the height coordinate indicator 6.3 is with an advantage performed by a laser.

The coordinate indicators 6.1, 6.2, 6.3 are typically the axes of the Cartesian coordinate system and it is advantageous if each of the axes of mutual movement of each of the machining tools and of the fastening device 2 is parallel to one of the coordinate indicators 6.1, 6.2, 6.3.

If two machining tools 1.1, 1.2 having mutually different working surfaces are used, the sequence or cycle of steps a) to g) is first performed using the first machining tool 1.1 and after the removal of the upper parts of the component 6 by the first machining tool 1.1 is finished, it is followed immediately or after further intermediate steps have been taken by the removal of lower parts of the component 6 by the second machining tool 1.2. Other intermediate steps may comprise, for example, repeated measuring of the coordinates of the points on the component being removed 6. The lower parts of the component are usually materially different from the upper ones. When removing a component of a given type for the first time, the moment of transition between the first and second machining tool is usually determined by the operator; when removing components of the same type repeatedly, data from the database can already be used, see below.

When removing the lower parts of the component 6 with the second machining tool 1.2, either the set of instructions created during the last run of step e) is used for the mutual movement of the first machining tool 1.1 and the fastening device 2, this set of instructions now being applied to the mutual movement of the second machining tool 1.2 and the fastening device 2, then it is proceeded according to steps f) and g), in which the second machining tool 1.2 is used as the machining tool, or steps a), b) and then steps c) to g) are performed again, in which the second machining tool 1.2 is used as the machining tool, and if at the first execution of step f) by the second machining tool 1.2 does not finish the component removal by the second machining tool 1.2, during subsequent repetitions of steps a) to g) the second machining tool 1.2 is used.

The component 6 removal by the first machining tool 1.1 is with an advantage finished after the upper material layers, typically a plastic housing, have been removed from the component 6. The removal of the component 6 by the second machining tool 1.2 is with an advantage finished after the lower material layers, typically a silicon layer, have been removed from the component 6.

The possibility of creating databases for repeated removal of components 6 of the same type is very advantageous. Before removing the component 6, the operator may have the choice whether to store the removal procedure in the database or, on the other hand, use data already stored in the database.

When creating the database, the type of component being removed 6 is determined and stored in the database and for this component being removed 6 instructions for the directions and speeds of mutual movement of this machining tool and the fastening device 2 as well as instructions for the speed of rotation of the working area of each of the machining tools used, with the database also storing data on the parameters of the working areas of the machining tools used and the sequence in which these tools were used. The database can be, for example, in the internal memory of the control unit, on a memory card, in the memory of a computer connected to the control unit, or on a network, etc.

With an advantage, the data from the database are then used to remove other components of the same type. Thanks to this, it is possible for the apparatus to be used by operators with minimum training.

It is assumed that an expert level operator first removes a component of a certain type at least once. After the procedures for this type of component are stored in the database, an operator with only basic training can remove other components of the same type. The procedure is that the expert level operator finetunes the procedure for the given component type, in particular the instructions for directions and speeds of mutual movement of each of the used machining tools and the fastening device 2, instructions for active surface rotational speed for each of the used machining tools, the sequence in which the machining tools are used, as well as the parameters of the working areas of the machining tools used, with all these data being stored in the database. For this finetuning, the expert operator can repeatedly go through the cycle of steps from a) to g), i.e., repeatedly measure during repeated runs of step a) and gradually iterate and optimize the procedure. He/she can also monitor the process of removal of the component in an image transmitted from the camera. Subsequently, the expert level operator evaluates the overall process of removing the component and, if considered satisfactory, keeps the values stored in the database for further use.

The control unit then sets the instructions in step d) for the basic level operator, who will then be removing the same type of component according to the data stored in the database. If multiple machining tools are used, the parameters of the working surfaces of these tools and the sequence of their use, including the moment when the removal by the first machining tool is to be finished and the removal by the second machining tool is to be started, will also be stored in the database, and can be used so that the whole process takes place automatically. When repeatedly removing the same type of component, it is usually sufficient to perform the measurement in step a) only once and also the sequence of steps from a) to f) can take place only once for the given machining tool, with the component removal by the respective machining tool being stopped already after the first run of step f). Then, if necessary, the removal of other parts of the component by the second machining tool potentially proceeds.

It is advantageous if, for at least one machining tool, the lateral and vertical forces exerted by this machining tool on the component being removed 6 are also measured. This can be used, for example, to adjust the settings and thus to adjust these forces in the event of damage to the machining tool tip due to excessive lateral force or damage to the printed circuit board 3 due to excessive vertical force.

The apparatus and method described above will find use, for example, in removing bonded integrated circuits, the so-called BGA chips. It is these BGA chips that will typically be the component being removed 6 by the apparatus according to the present invention. BGA stands for Ball Grid Array. It is a type of integrated circuit housing for surface mounting. It is characterized in that the base of the circuit is covered with contacts in the shape of a rectangular grid. This grid may not be completely regular, some parts may be omitted. Small balls are applied to the individual contacts, which after soldering form a conductor between the printed circuit board and the BGA housing.

In practice, these chips are designed so that the high integration processor forms a small silicon central part of the whole component. The individual outputs are conducted from this silicon part to the individual terminals, which are on the underside of the chip (so-called bonding). In practice, this means that the silicon part is always smaller (sometimes significantly) than the whole component and this allows us to program two separate working procedures for milling both the plastic part, i.e., the housing cover and the silicon part. Both parts need to be removed by a different method, i.e., by a different machining tool with a different machining speed moving on the component, possibly on a different trajectory, in such manner that the removal of the component is complete, and the printed circuit board is intact and clean.

The method and technology according to the present invention is based on:
- Precise measurement of the milled area by the measuring device 4, which allows identification of the defective component 6 according to the three independent coordinate indicators 6.1, 6.2, 6.3, with the machining tool work procedure respecting the potential inclination of the printed circuit board 3 base surface and the surface of the component being removed 6. We are assuming that the component 6 can be soldered to the printed circuit board at a different inclination angle than that of the printed circuit board.
- High-speed, typically two-phase removal of the defective component. Removal in two phases, independently of each other, is proposed due to the material difference of the components. However, only one phase can be used, typically for components that are materially uniform.

The basic requirement for the accuracy of the component removal is, above all, the prevention of damage to the other components on the printed circuit board 3 and the intactness of this board 3 for soldering and bonding of the replacement functional component.

After removing the component 6 in the manner described above in the apparatus described above, the printed circuit board 3 is ready for further use, cleaning and soldering and bonding of the replacement component.

### Industrial applicability

Only specialized and manufacturer-certified repairers have the authorization to perform interventions directly on the device hardware solution and therefore repair using the "on-board intervention" method applies to them, as described in the State of Art section. Such repair provider must guarantee the quality of the repair to the status of the original undamaged product. Repaired devices are usually certified as a new device and then this method of repair is authorized by the manufacturer.

It is the apparatus and method according to the present invention that solves the basic problem of the integrity of the "rest" of the device and thus enables the repeatability of repairs and provides a guarantee of quality.

The apparatus according to the present invention can be also potentially used for removing other layers of materials from base layers, other than components on printed circuit boards.

## Claims

1. An apparatus for removing a component (6) from printed circuit boards, equipped with at least one machining tool, a fastening device (2) for clamping a printed circuit board (3) and also by movable mechanisms for the mutual movement of at least one of the machining tools and the fastening device (2) along at least three different axes, wherein at least one of the machining tools is connected to the movable mechanisms and/or the fastening device (2) is connected to them, **characterized in that** said at least three different axes are mutually non-parallel, that the machining tools are selected from a group comprising milling machine and grinder, that the apparatus is also equipped with at least one measuring device (4) for measuring distances and that the movable mechanisms are also adapted for compound mutual movement of at least one machining tool and the fastening device (2) simultaneously along at least two axes, these movable mechanisms being connected to a control unit (9), to which at least one measuring device (4) is also connected.

2. The apparatus according to claim 1, **characterized in that** the machining tools are selected from a group comprising a first machining tool (1.1) and a second machining tool (1.2), wherein the first machining tool (1.1) has a first working surface and the second machining tool (1.2) has a second working surface, where the second working surface differs from the first working surface in at least one parameter selected from the group shape, material, surface roughness.

3. The apparatus according to claim 2, **characterized in that** the control unit (9) comprises a first work procedure block (9.1) for the first machining tool (1.1) and the fastening device (2) and a second work procedure block (9.2) for the second machining tool (1.2). ) and the fastening device (2).

4. The apparatus according to any of claims 1 to 3, **characterized in that** the movable mechanisms for the mutual movement of at least one of the machining tools and the fastening device (2) are adjustable in terms of range, speed and direction of movement for each of the axes of this mutual movement independently of the other axes.

5. The apparatus according to any of claims 1 to 4, **characterized in that** the measuring devices (4) comprise a camera and/or a laser and/or a mechanical probe.

6. Apparatus according to any of claims 1 to 5, **characterized in that** the at least one measuring device (4) is movable and is adapted to move synchronously with at least one of the machining tools in the direction of at least two axes selected from the group of axes of mutual movement of this machining tool and the fastening device (2).

7. A method of removing components (6) from printed circuit boards in the apparatus according to any of claims 1 to 6, comprising clamping the printed circuit board (3) with the component (6) to be removed in the fastening device (2) and determining the surface dimensions of the component (6), **characterized in that** it further comprises the following steps:
a) introducing a coordinate system for three-dimensional measurement with coordinate indicators (6.1, 6.2, 6.3), two of which are the planar coordinate indicators (6.1, 6.2) and the third is the height coordinate indicator (6.3), and in this coordinate system,
measuring for at least three points on the surface of the component (6) being removed, all three coordinates for each of these points according to the three coordinate indicators (6.1, 6.2, 6.3) and measuring for at least three points positioned on the surface of the printed circuit board (3) and concurrently outside of the component (6) being removed, all three coordinates according to the three coordinate indicators (6.1, 6.2, 6.3) for each of these points,
b) based on the measurement results, calculating mutual inclination of the board (3) surface and the surface of the component (6) being removed,
c) converting the measurement results and the determination of the planar dimensions of the component into setting of the ranges of the mutual movement of one of the machining tools and the fastening device (2),
d) setting by an operator or by the control unit instructions for directions and speeds of mutual movement of the given machining tool and the fastening device (2) as well as setting instructions for the rotational speed of the working surface of the given machining tool,
e) converting the settings made in steps c), d) into a set of instructions for the mutual movement of the given machining tool and the fastening device (2), wherein this mutual movement comprises movement along three mutually non-parallel axes of mutual movement of this machining tool and the fastening device (2), whereas for components (6) whose surface does not lie in any of the planes determined by pairs of axes selected from the group of axes of mutual movement of the given tool and the fastening device (2), this set of instructions also comprises compound mutual movement performed simultaneously along at least two axes selected from the group of axes of mutual movement of the given machining tool and the fastening device (2),
f) removing the component (6) by the machining tool according to the instruction set created in step e) and/or finishing the removal of the component (6) according to the set of instructions created in step e) or based on direct instruction of the operator, while if the removal of the component (6) by the machining tool has not been finished, the method continues by the following step g)
g) interrupting the removal and then repeating steps a) to f).

8. The method according to claim 7, **characterized in that** the measurement in step a) is performed by means of an operator and/or a camera and/or a laser and/or a mechanical probe.

9. The method according to claim 8, **characterized in that** it includes correcting aberrations by software when using the camera.

10. The method according to claim 8 or 9, **characterized in that** if the measurement is also performed by means of a camera, this camera participates in the measurement of the planar coordinates according to the planar coordinate indicators (6.1, 6.2), the method further comprising
selecting the points at which the planar coordinates are determined, this selection being done either by the operator on the basis of the camera-mediated image, or an automatic processing of camera image is done and the points are selected according to this processing, followed by
measuring the positions of the above selected points in the image obtained from the camera, and
converting these measured positions to real values of the planar coordinates of these points in the direction of the planar coordinate indicators (6.1, 6.2).

11. The method according to any of claims 8 to 10, **characterized in that** the measurement of the height coordinates according to the height coordinate indicator (6.3) is performed by a laser.

12. The method according to any of claims 7 to 11, **characterized in that** it further comprises
using two machining tools (1.1, 1.2) with mutually different working surfaces, and in a first stage,
performing a sequence of steps a) to f) or a cycle of steps a) to g) finished during its last repetition by step f), with the first machining tool (1.1), and when the removal of the upper parts of the component (6) by the first machining tool (1.1) is finished, removing immediately or after further intermediate steps the lower parts of the component (6) by the second machining tool (1.2).

13. The method according to claim 12, **characterized in that** when removing the lower parts of the component (6) by the second machining tool (1.2),
either the set of instructions created during the last run of step e) is used for mutual movement of the first machining tool (1.1) and the fastening device (2), whereas this set of instructions is now applied to the mutual movement of the second machining tool (1.2) and the fastening device (2), and then it is proceeded according to steps f) and g), in which the second machining tool (1.2) is used as the machining tool,
or steps a), b) and then steps c) to g) are performed again, in which the second machining tool (1.2) is used as the machining tool, whereas if the removal of the component in the first execution of step f) by the second machining tool (1.2) is not finished by the second machining tool (1.2), in the subsequent repetitions of steps a) to g) the second machining tool (1.2) is used.

14. The method according to any of claims 7 to 13, **characterized in that** the removal of the component (6) by the first machining tool (1.1) is finished after the upper material layers, typically the plastic housing, have been removed from the component (6), and that the removal of the component (6) by the second machining tool (1.2) is finished after the lower material layers, typically the silicon layer, have been removed from the component (6).

15. The method according to any of claims 7 to 14, **characterized in that** the parameters of the mutual movement of at least one of the machining tools and the fastening device (2), comprising direction, speed and range of this mutual movement, are in steps c), d) for each of the axes of mutual movement of the given machining tool and the fastening device (2) set independently of the parameters of mutual movement for the other axes of mutual movement for this machining tool and the fastening device (2).

16. The method according to any of claims 7 to 15, **characterized in that** it further includes
determining and storing in a database the type of component (6) being removed is, and for this component (6) being removed,
storing in the same database instructions for the speeds and directions of mutual movement of this machining tool and the fastening device (2) for each of the machining tools used, as well as instructions for the speed of rotation of the working surface for each of the used machining tools used, and
storing in the database also data on the parameters of working surfaces of the machining tools used, and the sequence in which these tools were used.

17. The method according to any of claims 7 to 16, **characterized in that** it further includes measuring, for at least one machining tool, of lateral and vertical forces exerted by the machining tool on the component (6) being removed.

## Patentansprüche

1. Gerät zum Entfernen von Komponenten (6) aus Leiterplatten, das mindestens ein Bearbeitungswerkzeug, eine Befestigungsvorrichtung (2) zum Fixieren der Leiterplatte (3) sowie Bewegungsmechanismen zum Bewegen mindestens eines der Bearbeitungswerkzeuge und der Befestigungsvorrichtung (2) relativ zueinander entlang mindestens drei verschiedener Achsen umfasst, wobei mindestens eines der Bearbeitungswerkzeuge und/oder die Befestigungsvorrichtung (2) an diesen beweglichen Mechanismen befestigt ist, **dadurch gekennzeichnet, dass** die mindestens drei verschiedenen Achsen nicht parallel zueinander verlaufen, dass die Bearbeitungswerkzeuge aus einer Gruppe ausgewählt sind, die Fräsmaschinen oder Schleifmaschinen umfasst, wobei das Gerät auch mit mindestens einer Wegmessvorrichtung (4) versehen ist, und dass die beweglichen Mechanismen auch für die zusammengesetzte relative Bewegung von mindestens einem Bearbeitungswerkzeug und der Befestigungsvorrichtung (2) entlang mindestens zweier Achsen gleichzeitig angepasst sind, wobei die beweglichen Mechanismen mit einer Steuereinheit (9) verbunden sind, mit der auch mindestens eine Wegmessvorrichtung (4) verbunden ist.

2. Gerät nach Anspruch 1, **dadurch gekennzeichnet, dass** die Bearbeitungswerkzeuge aus der Gruppe ausgewählt sind, die ein erstes Bearbeitungswerkzeug (1.1) und ein zweites Bearbeitungswerkzeug (1.2) umfasst, wobei das erste Bearbeitungswerkzeug (1.1) eine erste Wirkfläche und das zweite Bearbeitungswerkzeug (1.2) eine zweite Wirkfläche aufweist, wobei sich die zweite Wirkfläche von der ersten Wirkfläche in mindestens einem Parameter unterscheidet, der aus der Gruppe ausgewählt ist, die aus Form, Material und Oberflächenrauheit besteht.

3. Gerät nach Anspruch 2, **dadurch gekennzeichnet, dass** die Steuereinheit (9) einen ersten Block (9.1) des Arbeitsablaufs für das erste Bearbeitungswerkzeug (1.1) und die Befestigungsvorrichtung (2) und einen zweiten Block (9.2) des Arbeitsablaufs für das zweite Bearbeitungswerkzeug (1.2) und die Befestigungsvorrichtung (2) umfasst.

4. Gerät nach einem der Ansprüche 1 bis 3, **dadurch gekennzeichnet, dass** die beweglichen Mechanismen für die relative Bewegung mindestens eines der Bearbeitungswerkzeuge und der Befestigungsvorrichtung (2) in Bereich, Geschwindigkeit und Bewegungsrichtung für jede der Achsen dieser relativen Bewegung unabhängig von den anderen Achsen dieser relativen Bewegung einstellbar sind.

5. Gerät nach einem der Ansprüche 1 bis 4, **dadurch gekennzeichnet, dass** die Wegmessvorrichtungen (4) eine Kamera und/oder einen Laser und/oder eine mechanische Sonde umfassen.

6. Gerät nach einem der Ansprüche 1 bis 5, **dadurch gekennzeichnet, dass** die mindestens eine Wegmessvorrichtung (4) beweglich ist und mit mindestens einem der Bearbeitungswerkzeuge in Richtung von mindestens zwei Achsen, die aus der Gruppe der Achsen der relativen Bewegung dieses Bearbeitungswerkzeugs und der Vorrichtung (2) ausgewählt sind, synchron bewegbar ist.

7. Verfahren zum Entfernen von Komponenten (6) aus Leiterplatten in einem Gerät nach einem der Ansprüche 1 bis 6, wobei die Leiterplatte (3) mit der zu entfernenden Komponente (6) in der Befestigungsvorrichtung (2) fixiert wird und die Flächenabmessungen der Komponente (6) ermittelt werden, **dadurch gekennzeichnet, dass** es ferner die folgenden Schritte umfasst:
a) ein Koordinatensystem zur dreidimensionalen Messwerterfassung mit Koordinatenindikatoren (6.1, 6.2, 6.3) wird aufgebaut, wobei zwei von denen Flächen-Koordinatenindikatoren (6.1, 6.2) und der dritte ein Relief-Koordinatenindikator (6.3) sind, und in diesem Koordinatensystem werden für mindestens drei Punkte auf der Oberfläche der zu entfernenden Komponente (6) alle drei Koordinaten für jeden dieser Punkte nach den drei Koordinatenindikatoren (6. 1, 6.2, 6.3) und auch für mindestens drei Punkte, die auf der Oberfläche der Leiterplatte (3) und gleichzeitig außerhalb der zu entfernenden Komponente (6) liegen, für jeden dieser Punkte alle drei Koordinaten nach den drei Koordinatenindikatoren (6.1, 6.2, 6.3) gemessen,
b) auf der Grundlage der Messergebnisse wird die relative Neigung der Oberfläche der Platte (3) und der Oberfläche der zu entfernenden Komponente (6) berechnet
c) die Ergebnisse der Messung und Bestimmung der Flächenabmessungen der Komponente werden in die Einstellung der relativen Bewegungsbereiche einer der Bearbeitungswerkzeuge und der Befestigungsvorrichtung (2) übertragen,
d) der Bediener oder die Steuereinheit legt die Vorgabe für die Richtungen und Geschwindigkeiten der relativen Bewegung des jeweiligen Bearbeitungswerkzeugs und der Befestigungsvorrichtung (2) sowie die Vorgabe für die Drehgeschwindigkeit der Wirkfläche des Bearbeitungswerkzeugs fest,
e) die in den Schritten c), d) vorgenommenen Einstellungen werden in einen Befehlssatz für die relative Bewegung des jeweiligen Bearbeitungswerkzeugs und der Befestigungsvorrichtung (2) übertragen, wobei diese relative Bewegung eine Bewegung entlang dreier zueinander nicht paralleler Achsen der relativen Bewegung der Bearbeitungswerkzeuge und der Befestigungsvorrichtung (2) umfasst, wobei im Falle der Entfernung von Komponenten (6), deren Oberfläche in keiner der Ebenen liegt, die durch die Achsenpaare definiert sind, die aus der Gruppe der Achsen der relativen Bewegung der Bearbeitungswerkzeuge und der Befestigungsvorrichtung (2) ausgewählt sind, dieser Befehlssatz auch eine zusammengesetzte relative Bewegung umfasst, die gleichzeitig entlang mindestens zweier Achsen ausgeführt wird, die aus der Gruppe der Achsen der relativen Bewegung der Bearbeitungswerkzeuge und der Befestigungsvorrichtung (2) ausgewählt sind,
f) die Entfernung der Komponente (6) durch das Bearbeitungswerkzeug gemäß dem in Schritt e) erstellten Befehlssatz wird durchgeführt und/oder die Entfernung der Komponente (6) gemäß dem in Schritt e) erstellten Befehlssatz oder auf der Grundlage einer direkten Anweisung des Bedieners wird beendet, wenn die Entfernung der Komponente (6) durch das Bearbeitungswerkzeug nicht beendet wurde, wird das Verfahren mit dem folgenden Schritt g) fortgesetzt,
g) die Entfernung wird unterbrochen und die Schritte a) bis f) werden wiederholt.

8. Verfahren nach Anspruch 7, **dadurch gekennzeichnet, dass** die Messung in Schritt a) durch einen Bediener und/oder eine Kamera und/oder einen Laser und/oder eine mechanische Sonde durchgeführt wird.

9. Verfahren nach Anspruch 8, **dadurch gekennzeichnet, dass** bei Verwendung der Kamera die Aberrationen durch Software korrigiert werden.

10. Verfahren nach Anspruch 8 oder 9, **dadurch gekennzeichnet, dass**, wenn die Messung auch mittels einer Kamera durchgeführt wird, die Kamera an der Messung der Flächenkoordinaten nach den Flächen-Koordinatenindikatoren (6.1, 6. 2) teilnimmt, wobei die Punkte, an denen die Flächenkoordinaten bestimmt werden, entweder vom Bediener auf der Grundlage des von der Kamera vermittelten Bildes ausgewählt werden oder eine automatische Verarbeitung des Kamerabildes durchgeführt wird und die Punkte dementsprechend ausgewählt werden, woraufhin die Positionen der vorgenannten ausgewählten Punkte in dem von der Kamera erhaltenen Bild gemessen werden, die anschließend in reale Werte der Flächenkoordinaten dieser Punkte in Richtung der Flächen-Koordinatenindikatoren (6.1, 6.2) umgerechnet werden.

11. Verfahren nach einem der Ansprüche 8 bis 10, **dadurch gekennzeichnet, dass** die Messung der Höhenkoordinaten gemäß dem Höhen-Koordinatenindikator (6.3) mittels Laser durchgeführt wird.

12. Verfahren nach einem der Ansprüche 7 bis 11, **dadurch gekennzeichnet, dass** zwei Bearbeitungswerkzeuge (1.1, 1.2) mit voneinander verschiedenen Wirkflächen verwendet werden, wobei eine Abfolge der Schritte a) bis f) oder ein Zyklus der Schritte a) bis g), der bei der letzten Wiederholung von Schritt f) endet, zunächst mit dem ersten Bearbeitungswerkzeug (1. 1) durchgeführt wird, und nach Beendigung der Entfernung der oberen Teile der Komponente (6) mit dem ersten Bearbeitungswerkzeug (1.1) die Entfernung der unteren Teile der Komponente (6) mit dem zweiten Bearbeitungswerkzeug (1.2) unmittelbar oder nach weiteren Zwischenschritten folgt.

13. Verfahren nach Anspruch 12, **dadurch gekennzeichnet, dass** beim Entfernen der unteren Teile der Komponente (6) durch das zweite Bearbeitungswerkzeug (1.2) entweder der im letzten Ablauf von Schritt e) erzeugte Befehlssatz für die relative Bewegung des ersten Bearbeitungswerkzeugs (1.1) und der Befestigungsvorrichtung (2) verwendet wird, wobei dieser Befehlssatz nun auf die relative Bewegung des zweiten Bearbeitungswerkzeugs (1. 2) und der Befestigungsvorrichtung (2) angewendet wird und dann mit den Schritten f) und g) fortgefahren wird, in denen das zweite Bearbeitungswerkzeug (1.2) als Bearbeitungswerkzeug verwendet wird, oder die Schritte a), b) und dann wieder die Schritte c) bis g) durchgeführt werden, in denen das zweite Bearbeitungswerkzeug (1. 2) als Bearbeitungswerkzeug verwendet wird, wobei, wenn die Entfernung der Komponente durch das zweite Bearbeitungswerkzeug (1.2) bei der erstmaligen Durchführung von Schritt (f) mit dem zweiten Bearbeitungswerkzeug (1.2) nicht abgeschlossen ist, das zweite Werkzeug (1.2) bei den nachfolgenden Wiederholungen der Schritte (a) bis (g) verwendet wird.

14. Verfahren nach einem der Ansprüche 7 bis 13, **dadurch gekennzeichnet, dass** das Entfernen der Komponente (6) durch das erste Bearbeitungswerkzeug (1.1) abgeschlossen wird, nachdem die oberen Materialschichten, typischerweise das Kunststoffgehäuse, von der Komponente (6) entfernt wurden, und dass das Entfernen der Komponente (6) durch das zweite Bearbeitungswerkzeug (1.2) abgeschlossen wird, nachdem die unteren Materialschichten, typischerweise die Siliziumschicht, von der Komponente (6) entfernt wurden.

15. Verfahren nach einem der Ansprüche 7 bis 14, **dadurch gekennzeichnet, dass** die Parameter der relativen Bewegung von mindestens einem der Bearbeitungswerkzeuge und/oder der Befestigungsvorrichtung (2), die die Richtung, die Geschwindigkeit und den Bereich dieser relativen Bewegung umfassen, in den Schritten c), d) für jede der Achsen der relativen Bewegung des jeweiligen Bearbeitungswerkzeugs und der Befestigungsvorrichtung (2) unabhängig von den Parametern der relativen Bewegung für die anderen Achsen der relativen Bewegung des Bearbeitungswerkzeugs und der Befestigungsvorrichtung (2) eingestellt werden.

16. Verfahren nach einem der Ansprüche 7 bis 15, **dadurch gekennzeichnet, dass** die Art der zu entfernenden Komponente (6) bestimmt und in einer Datenbank gespeichert wird und für diese zu entfernende Komponente (6) eine Vorgabe für die Richtungen und Geschwindigkeiten der relativen Bewegung des Bearbeitungswerkzeugs und der Befestigungsvorrichtung (2) für jedes der verwendeten Bearbeitungswerkzeuge und eine Vorgabe für die Drehgeschwindigkeit der Wirkfläche für jedes der verwendeten Bearbeitungswerkzeuge ebenfalls in derselben Datenbank gespeichert werden, wobei die Datenbank auch die Daten über die Parameter der Wirkflächen der verwendeten Bearbeitungswerkzeuge und die Reihenfolge, in der diese Werkezeuge verwendet wurden, speichert.

17. Verfahren nach einem der Ansprüche 7 bis 16, **dadurch gekennzeichnet, dass** für mindestens ein Bearbeitungswerkzeug auch die seitliche und vertikale Kraft gemessen wird, die von dem Bearbeitungswerkzeug auf die zu entfernende Komponente (6) ausgeübt wird.

## Revendications

1. Dispositif pour retirer des composants (6) des cartes de circuits imprimés équipé d'au moins un outil d'usinage, d'un dispositif (2) de fixation pour fixer les cartes (3) de circuits imprimés ainsi que des mécanismes mobiles pour un déplacement réciproque d'au moins l'un des outils d'usinage et du dispositif (2) de fixation selon au moins trois axes différents, au moins un des outils d'usinage et/ou le dispositif (2) de fixation étant relié à ces mécanismes mobiles, **caractérisé en ce qu'**au moins les trois axes différents ne sont pas parallèles entre eux, que les outils d'usinage sont choisis dans le groupe comprenant les fraiseuses ou les meuleuses, le dispositif étant également équipé d'au moins un appareil (4) de mesure pour mesurer des distances et les mécanismes mobiles étant adaptés également au déplacement réciproque d'au moins un outil d'usinage et un dispositif (2) de fixation selon au moins deux axes simultanément, ces mécanismes mobiles étant reliés à une unité (9) de commande à laquelle au moins un appareil (4) de mesure est également relié.

2. Dispositif selon la revendication 1 **caractérisé en ce que** les outils d'usinage sont choisis dans le groupe comprenant un premier outil (1.1) d'usinage et un deuxième outil (1.2) d'usinage, le premier outil (1.1) d'usinage ayant une première surface active et le deuxième outil (1.2) d'usinage ayant une deuxième surface active, lorsque la deuxième surface active diffère de la première surface active par au moins un paramètre choisi parmi le groupe forme, matériau, rugosité de surface.

3. Dispositif selon la revendication 2 **caractérisé en ce que** l'unité (9) de commande comprend un premier block (9.1) de procédé de travail pour le premier outil (1.1) d'usinage et le dispositif (2) de fixation et un deuxième block (9.2) de procédé de travail pour le deuxième outils (1.2) d'usinage et le dispositif (2) de fixation.

4. Dispositif selon l'une quelconque des revendications 1 à 3 **caractérisé en ce que** les mécanismes mobiles pour un déplacement réciproque d'au moins l'un des outils d'usinage et du dispositif (2) de fixation sont réglables en plage, vitesse et sens de déplacement pour chacun des axes de ce déplacement réciproque indépendamment des autres axes de ce déplacement réciproque.

5. Dispositif selon l'une quelconque des revendications 1 à 4 **caractérisé en ce que** les appareils (4) de mesure comprennent une caméra et/ou un laser et/ou une sonde mécanique.

6. Dispositif selon l'une quelconque des revendications 1 à 5 **caractérisé en ce qu'**au moins un appareil (4) de mesure est mobil et adapté à un déplacement synchrone avec au moins un des outils d'usinage dans la direction d'au moins deux axes choisis parmi le groupe d'axes de déplacement réciproque de cet outil d'usinage et du dispositif (2) de fixation.

7. Procédé de retrait de composants (6) des cartes de circuits imprimés dans le dispositif selon l'une quelconque des revendications 1 à 6, dans lequel la carte (3) de circuits imprimés avec le composant (6) à retirer est fixée dans le dispositif (2) de fixation et les dimensions de surface du composant (6) sont déterminées, **caractérisé en ce qu'**il comprend en outre les étapes suivantes :
a) un système de coordonnées pour la mesure tridimensionnelle avec des indicateurs (6.1, 6.2, 6.3) de coordonnées sera mis en ouvre, deux d'entre eux étant les indicateurs (6.1, 6.2) de coordonnées surfaciques et le troisième étant un indicateur (6.3) de coordonnées de relief, et dans ce système de coordonnées, pour au moins trois points à la surface du composant (6) à retirer, les trois coordonnées sont mesurées pour chacun de ces points selon les trois indicateurs (6.1, 6.2, 6.3) de coordonnées et également pour au moins trois points situés sur la surface de la carte (3) de circuits imprimés, et simultanément, en dehors du composant (6) à retirer, les trois coordonnées sont mesurées selon les trois indicateurs (6.1, 6.2, 6.3) de coordonnées pour chacun de ces points.
b) un calcul de la pente relative de la surface de la carte (3) et de la surface du composant (6) à retirer sera effectué sur la base des résultats de mesure
c) les résultats de mesure et la détermination des dimensions de surface du composant seront traduits par le réglage des plages de déplacement réciproque de l'un des outils d'usinage et du dispositif (2) de fixation,
d) un opérateur ou l'unité de commande procède au réglage de la prescription pour les directions et les vitesses de déplacement réciproque de l'outil d'usinage et du dispositif (2) de fixation donnés ainsi que la prescription pour la vitesse de rotation de la surface active de l'outil d'usinage donné,
e) les réglages effectués aux étapes c), d) seront traduits dans un ensemble de commandes pour le déplacement réciproque de l'outil d'usinage donné et du dispositif (2) de fixation, ce déplacement réciproque comprenant un déplacement le long des trois axes mutuellement non parallèles du déplacement réciproque de cet outil d'usinage et du dispositif (2) de fixation, en cas de retrait des composants (6) dont la surface ne se trouve dans aucun des plans déterminés par des paires d'axes choisis dans le groupe d'axes de déplacement réciproque de l'outil d'usinage et du dispositif (2) de fixation donnés, cet ensemble de commandes comprenant également un déplacement réciproque composé effectué simultanément le long d'au moins deux axes choisis parmi les axes de déplacement réciproque de l'outil d'usinage et du dispositif (2) de fixation données,
f) le retrait d'un composant (6) est effectué par l'outil d'usinage selon l'ensemble de commandes créé à l'étape e) et/ou la fin de retrait d'un composant (6) selon l'ensemble de commandes créées à l'étape e) ou selon une commande directe de l'opérateur, si le retrait du composant (6) par l'outil d'usinage n'a pas été fini, le procédé se poursuit par l'étape g) suivante,
g) le retrait est interrompu et les étapes a) à f) sont répétées.

8. Procédé selon la revendication 7 **caractérisé en ce que** la mesure à l'étape a) est effectuée par l' opérateur et/ou la caméra et/ou le laser et/ou la sonde mécanique.

9. Procédé selon la revendication 8 **caractérisé en ce qu'**en cas d'utilisation de la caméra, ses aberrations sont corrigées par un logiciel.

10. Procédé selon la revendication 8 ou 9 **caractérisé en ce que,** si la mesure est effectuée également au moyen de la caméra, cette caméra participe aux mesures des coordonnées surfaciques selon les indicateurs (6.1, 6.2) de coordonnées surfaciques, les points auxquels les coordonnées de surface sont déterminées sont soit sélectionnés par l'opérateursur la base de l'image médiatisée par la caméra ou un traitement automatique de l'image de la caméra est effectué et les points sont sélectionnés en conséquence, après quoi les positions des points sélectionnés susmentionnés sont mesurées dans l'image obtenue à partir de la caméra, qui sont ensuite converties en valeurs réelles des coordonnées de surface de ces points dans la direction des indicateurs (6.1, 6.2) de coordonnées surfaciques.

11. Procédé selon l'une quelconque des revendications 8 à 10 **caractérisé en ce que** la mesure des coordonnées de hauteur selon l'indicateur (6.3) de coordonnées de hauteur est effectué par le laser.

12. Procédé selon l'une quelconque des revendications 7 à 11 **caractérisé en ce que** deux outils (1.1, 1.2) d'usinage sont utilisés ayant chacun une surface active différente, une séquence d'étapes a) à f) étant effectuée en premier, ou un cycle d'étapes a) à g) terminé lors de la dernière répétition de l'étape f), avec le premier outil (1.1) d'usinage et après que le retrait, par le premier outil (1.1) d'usinage, des parties supérieures du composant (6) soit terminé, le retrait des parties inférieures du composant (6) par le deuxième outil (1.2) d'usinage suit immédiatement ou après avoir effectué d'autres étapes intermédiaires.

13. Procédé selon la revendication 12 **caractérisé en ce que** lors du retrait des parties inférieures du composant (6) par le deuxième outil (1.2) d'usinage, c'est soit l'ensemble de commandes créé lors de la dernière exécution de l'étape e) pour le déplacement réciproque du premier outil (1.1) d'usinage et du dispositif (2) de fixation qui est utilisé, cet ensemble de commandes étant maintenant appliqué au déplacement réciproque du deuxième outil (1.2) d'usinage et du dispositif (2) de fixation et ensuite il est procédé selon les étapes f) et g) dans lesquelles un deuxième outil (1.2) d'usinage est utilisé comme outil d'usinage, soit les étapes a), b) sont effectué à nouveau et ensuite les étapes c) à g) dans lesquelles un deuxième outil (1.2) d'usinage est utilisé comme outil d'usinage, tandis que, si, lors de la première exécution de l'étape f) par le deuxième outil (1.2) d'usinage le retrait du composant par le deuxième outil (1.2) d'usinage n'est pas terminé, le deuxième outil (1.2) d'usinage est utilisé lors des répétitions ultérieures des étapes a) à g).

14. Procédé selon l'une quelconque des revendications 7 à 13 **caractérisé en ce que** le retrait du composant (6) par le premier outil (1.1) d'usinage se termine après que des couches de matériau supérieures, typiquement un boîtier en plastique, ont été retirées du composant (6), et que le retrait du composant (6) par le deuxième outil (1.2) d'usinage se termine après que des couches de matériau inférieures, typiquement la couche de silicium, ont été retirées du composant (6).

15. Procédé selon l'une quelconque des revendications 7 à 14 **caractérisé en ce que** les paramètres du déplacement réciproque d'au moins un des outils d'usinage et du dispositif (2) de fixation comprenant le sens, la vitesse et la plage de ce déplacement réciproque sont réglés aux étapes c), d) pour chacun des axes de déplacement réciproque de l'outil d'usinage et du dispositif (2) de fixation donnés indépendamment des paramètres de déplacement réciproque pour les autres axes de déplacement réciproque de cet outil d'usinage et du dispositif (2) de fixation.

16. Procédé selon l'une quelconque des revendications 7 à 15 **caractérisé en ce que** le type du composant (6) à retirer est déterminé et stocké dans la base de données et pour ce composant (6) à retirer, dans la même base de données, la prescription des sens et des vitesses de déplacement réciproque de cet outil d'usinage et du dispositif (2) de fixation est également stockée pour chacun des outils d'usinage utilisés ainsi que la prescription pour la vitesse de rotation de la surface active pour chacun des outils d'usinage utilisés, des données sur les paramètres des surfaces actives des outils d'usinage utilisés ainsi que la séquence dans laquelle ces outils ont été utilisés étant également stocké dans la base de données.

17. Procédé selon l'une quelconque des revendications 7 à 16 **caractérisé en ce que** la mesure des forces latérale et verticale que cet outil d'usinage exerce sur le composant (6) à retirer est effectuée pour au moins un outil d'usinage.
